# FASCICULE DE BREVET EUROPEEN

(11) **EP 2 198 070 B1**
(45) Date de publication et mention de la délivrance du brevet: **04.10.2017**
(21) Numéro de dépôt: 08805229.5
(22) Date de dépôt: 10.10.2008
(51) Int. Cl.: C23C 14/16, C23C 14/24, C23C 14/56

(54) **GÉNÉRATEUR DE VAPEUR INDUSTRIEL POUR LE DÉPÔT D'UN REVÊTEMENT D'ALLIAGE SUR UNE BANDE MÉTALLIQUE**
INDUSTRIELLER DAMPFERZEUGER ZUM AUFBRINGEN EINER LEGIERUNGSSCHICHT AUF EINEM METALLBAND
INDUSTRIAL STEAM GENERATOR FOR DEPOSITING AN ALLOY COATING ON A METAL BAND

(30) Priorité: 12.10.2007 EP 07447056
(43) Date de publication de la demande: 23.06.2010
(73) Titulaire: ArcelorMittal, 1160 Luxembourg (LU)
(72) Inventeur: BANASZAK, Pierre, B-4683 Vivegnis (BE); MARNEFFE, Didier, B-4480 Engis (BE); SILBERBERG, Eric, B-5340 Haltinne-Gesves (BE); VANHEE, Luc, F-08600 Fromelennes (FR)
(74) Mandataire: Lavoix
(86) Numéro de dépôt international: PCT/EP2008/063638
(87) Numéro de publication internationale: WO 2009/047333

(56) Documents cités:
- EP-A- 1 174 526
- WO-A-2005/116290

## Description

### Objet de l'invention

La présente invention se rapporte à un générateur de vapeur industriel pour revêtir sous vide et en continu un substrat en mouvement, plus particulièrement une bande métallique, au moyen d'une vapeur métallique en vue de former une couche de métal et de préférence une couche d'alliage métallique sur sa surface, de manière à lui assurer une excellente résistance à la corrosion tout en conservant de bonnes caractéristiques d'emboutissage et de soudabilité.

### Etat de la technique

Il est connu depuis la fin des années 1980 que le dépôt de certains alliages, tels que ZnMg, à la surface d'une bande d'acier, a un rôle protecteur de l'acier. L'excellente tenue en corrosion de l'alliage ZnMg est attribuée à la nature des produits de corrosion formés à la surface de la bande selon une couche extrêmement dense jouant le rôle de film-barrière.

Un tel dépôt d'alliage n'est généralement pas possible au moyen des techniques habituelles telles que le dépôt électrolytique, le revêtement au trempé, etc. Ainsi, à la pression atmosphérique, au trempé, on peut avoir contamination du bain de métal liquide par l'oxygène de l'air, qui forme des oxydes à la surface du bain.

La seule issue possible est donc souvent l'évaporation sous vide du métal liquide, pur ou sous forme d'alliage (technique PVD, *Pressure Vapor Déposition).*

Dans le cadre de cette technique, il est connu de placer le substrat dans une enceinte sous vide maintenue à basse température et contenant un creuset de métal fondu. Le dépôt s'effectue alors sur toutes les parois dont la température est inférieure à la température de la vapeur métallique. Pour augmenter le rendement de dépôt sur le substrat et éviter les gaspillages, on a donc intérêt à chauffer les parois de l'enceinte.

Le document US-A-5,002,837 décrit le dépôt par évaporation d'un revêtement bicouche Zn/ZnMg avec une phase totalement alliée Zn₂Mg ou Zn₂Mg/Zn₁₁Mg₂.

Dans le document EP-A-0 730 045, on décrit un revêtement de bande d'acier avec un dépôt de 3 ou 5 couches d'alliage ZnMg déposées sous vide et assurant une très bonne résistance à la corrosion avec un minimum de poudrage lors de l'emboutissage.

Dans le document WO-A-02/06558 (ou EP-A-1 174 526), un revêtement ZnMg est obtenu sous vide par co-évaporation à partir de deux creusets, l'un contenant le zinc et l'autre le magnésium. Avant projection sur la bande, les vapeurs sont mélangées dans un éjecteur et chaque conduite de vapeur présente un dispositif d'étranglement ou une restriction sous forme de plaques munies de trous ou fentes de différentes formes, qui permettent d'obtenir un jet de vapeur à la vitesse sonique et un débit de vapeur maximum dans l'éjecteur. L'admission de la vapeur à partir des creusets dans la chambre à vide, via l'éjecteur est effectuée en ouvrant des vannes tout ou rien ou à deux positions « On/Off » (*mechanical shutters*) qui sont respectivement ouvertes au démarrage et fermées à l'arrêt du système. L'utilisation de ces vannes apporte une solution potentielle au problème de chauffage ou refroidissement lors du démarrage ou de l'arrêt. S'il est nécessaire de réchauffer la vapeur de manière contrôlée pour éloigner le risque de recondensation, il est proposé d'utiliser un échangeur de chaleur tel qu'un filtre poreux conducteur et chauffé par induction dans la conduite traversée par la vapeur.

Dans le document WO-A-02/14573, on décrit l'élaboration d'un revêtement à partir d'un revêtement zingué de base obtenu par un procédé conventionnel de galvanisation au trempé ou électrozingué, lui-même revêtu ensuite de magnésium sous vide. Un chauffage rapide par induction permet de remettre pendant quelques secondes le dépôt en fusion et d'obtenir après refroidissement, une répartition microstructurale favorable de phase alliée ZnMg dans toute l'épaisseur de la couche.

La Demanderesse a en outre proposé un produit industriel bicouche électro-zingué/alliage ZnMg obtenu par la voie PVD (EP-A-0 756 022), ainsi qu'une amélioration du procédé avec un système de chauffage infrarouge pour réaliser l'alliation du magnésium avec le zinc afin de minimiser la formation de phase intermétallique fragile FeZn.

Dans le document WO-A-97/47782, on décrit un procédé pour revêtir en continu un substrat en mouvement dans lequel la vapeur métallique est générée en chauffant par induction un creuset contenant un bain constitué par le métal de revêtement dans une enceinte sous vide. La vapeur s'échappe du creuset par une conduite qui l'amène vers un orifice de sortie, de préférence calibré, de manière à former un jet dirigé vers la surface du substrat à revêtir. L'utilisation d'un orifice sous forme d'une fente longitudinale de section étroite permet la régulation du débit massique de vapeur, à une vitesse sonique constante le long de la fente (col sonique), ce qui procure l'avantage d'obtenir un dépôt uniforme. On se référera par la suite à cette technique en utilisant l'acronyme « JVD » (pour *Jet Vapor Déposition*).

Cette technologie présente cependant plusieurs défauts, dont notamment :
- l'alimentation permanente en métal liquide implique de prévoir le retour à la cuve de celui-ci en un ou plusieurs points ;
- le métal liquide comprenant des impuretés, il y a concentration de ces impuretés en surface du bain suite à l'évaporation, ce qui réduit le débit. Une solution serait un écrémage de la surface ou un recyclage de la charge mais toute opération mécanique est rendue difficile sous vide ;
- la difficulté d'adapter la fente d'évaporation à une largeur de bande variable, ce qui implique des moyens d'occultation de part et d'autre de la fente, et partant la réalisation d'une étanchéité à la vapeur sous vide et à 700°C, ce qui n'est pas aisé à réaliser ;
- la difficulté d'occulter la fente lorsque le mouvement de la bande s'interrompt, ce qui impliquerait la présence d'une vanne linéaire étanche sur une longueur typique de 2 mètres ou plus ;
- la grande inertie thermique du système (au moins plusieurs minutes) ;
- le chauffage, réalisé par induction sous vide, nécessite de passer toute la puissance électrique de chauffage au travers de la paroi étanche au vide, ce qui ne facilite pas l'accessibilité et la maintenabilité de l'installation.

Par ailleurs, l'état de la technique n'apporte pas de solution satisfaisante à la nécessité de réaliser le co-dépôt de deux métaux distincts, impliquant le mélange de deux jets en sortie de l'évaporateur. L'utilisation de boîtes de mélange intermédiaires à chicanes n'a apporté aucun résultat probant.

Il est possible de réaliser des alliages de métal de revêtement (ex. 85% Zn, 15% Mg) en contrôlant rigoureusement la concentration des deux métaux dans le creuset. Toutefois ce contrôle implique de grandes difficultés de gestion du système, et en particulier l'homogénéité dans le creuset, surtout si celui-ci n'est pas de section circulaire.

On sait aussi que la société Sidrabe Inc. (Lettonie) a proposé par ailleurs un procédé PVD où la source de métal en fusion est déportée en dehors de la chambre de dépôt sous vide, initialement pour éviter qu'à haute vitesse d'évaporation, de fines particules de magnésium solide ne se déposent sur le substrat. La séparation de la zone de fusion de la boîte d'évaporation par une conduite de communication permet de réguler plus aisément l'évaporation. Une mesure de pression de vapeur est notamment effectuée au niveau de cette conduite (par ex. dans SVC 505/856-7188 42nd Annual Technical Conference Proceedings (1999), pp.39-42).

Le document WO-A-2005/116290 propose une installation de ce type où les niveaux de métal liquide respectifs dans le creuset de fusion et dans le creuset d'évaporation sont régulés au moyen d'une pompe magnétohydrodynamique.

### Buts de l'invention

La présente invention vise à fournir une solution qui permette de s'affranchir des inconvénients de l'état de la technique.

En particulier, l'invention vise à atteindre notamment les objectifs suivants :
- simplicité de réalisation ;
- accessibilité et maintenance aisées du ou des creusets ;
- excellente uniformité du dépôt métallique et mécanisme simple d'adaptation de la tête de dépôt à des largeurs de bande variables et pouvant excéder 2 mètres ;
- débit de vapeur maximalisé ;
- brassage magnétique élevé évitant la ségrégation des impuretés en surface ;
- régulation aisée du débit de vapeur, par contrôle de la puissance électrique et/ou de la température de surface d'évaporation ;
- installation facilitée par des vannes dans des conduites cylindriques de diamètre réduit.

### Principaux éléments caractéristiques de l'invention

La présente invention se rapporte, selon la revendication principale 1, à un générateur de vapeur pour le dépôt d'un revêtement métallique sur un substrat, de préférence une bande d'acier, comprenant une chambre à vide sous forme d'une enceinte, munie de moyens pour y assurer un état de dépression par rapport au milieu extérieur et munie de moyens permettant l'entrée et la sortie du substrat, tout en étant essentiellement étanche par rapport au milieu extérieur, ladite enceinte englobant une tête de dépôt de vapeur, appelée éjecteur, conformé pour créer un jet de vapeur métallique à la vitesse sonique en direction de et perpendiculaire à la surface du substrat, ledit éjecteur étant en communication de manière étanche au moyen d'une conduite d'alimentation avec au moins un creuset contenant un métal de revêtement sous forme liquide et situé à l'extérieur de la chambre à vide, caractérisé en ce que l'éjecteur comprend une fente longitudinale de sortie de la vapeur, jouant le rôle de col sonique, s'étendant sur toute la largeur du substrat, un milieu filtrant ou un organe de perte de charge en matière frittée étant disposé dans l'éjecteur immédiatement avant ladite fente sur le passage de la vapeur pour uniformiser la vitesse d'écoulement de la vapeur sortant de l'éjecteur par le col sonique. On entend par uniformiser la vitesse d'écoulement uniformiser et redresser les vecteurs vitesse de ladite vapeur.

Selon des formes d'exécution préférées de l'invention, mentionnées dans les revendications dépendantes, le générateur de vapeur selon l'invention comporte en outre une ou plusieurs des caractéristiques suivantes, qui doivent être considérées comme prises en combinaison avec les caractéristiques de la revendication principale :
- ledit milieu filtrant ou organe de perte de charge est réalisé en titane ;
- ledit milieu filtrant ou organe de perte de charge est un tamis métallique en fibres inox frittées ;
- le générateur comprend des moyens pour réguler la pression de vapeur métallique dans l'éjecteur sans provoquer d'inertie lors des transitoires de pression ;
- lesdits moyens de régulation comprennent une vanne proportionnelle avec optionnellement un dispositif de perte de charge disposés dans ladite conduite ;
- la vanne proportionnelle est une vanne de type papillon ;
- le générateur comporte des moyens pour ajuster la longueur de la fente longitudinale à la largeur du substrat ;
- lesdits moyens comprennent des moyens de rotation de l'éjecteur autour de sa conduite d'alimentation ;
- le creuset contient un mélange de métaux sous forme liquide ;
- le creuset est alimenté par pompage ou par gravité du métal liquide à partir d'un four de fusion ;
- le creuset comporte un inducteur monté à l'extérieur, pour assurer le brassage magnétique du métal liquide ;
- le creuset comporte une purge vers le four de fusion par pompage ou écoulement gravitaire ;
- le creuset comporte des moyens de mesure de masse extérieurs pour y réguler le niveau de métal liquide ;
- l'éjecteur, la conduite et le creuset sont isolés thermiquement du milieu extérieur et chauffés par un des éléments chauffants à rayonnement, appelés simplement plus loin « four à rayonnement » ;
- le générateur comporte des moyens de chauffage optionnels de l'enceinte sous vide ;
- le générateur comporte deux creusets contenant des métaux sous forme liquide différents ;
- chaque creuset est relié par une conduite propre à un mélangeur, lui-même en communication avec l'éjecteur ;
- chaque conduite comporte une vanne avec optionnellement un dispositif de perte de charge permettant l'ajustement des concentrations de chaque métal lors du mélange des vapeurs à déposer sur le substrat et la régulation de la pression des vapeurs métalliques dans le mélangeur sans provoquer d'inertie lors des transitoires de pression ;
- le mélangeur est l'éjecteur lui-même et comporte un milieu filtrant en matière frittée permettant d'uniformiser la vitesse d'écoulement de la vapeur de chaque métal sortant de l'éjecteur ;
- ledit milieu filtrant en matière frittée est réalisé en titane ou se présente sous la forme d'un tamis métallique en fibres inox frittées.

### Brève description des figures

Les figures 1A à 1C représentent schématiquement plusieurs exemples d'exécution du générateur de vapeur industriel selon la présente invention.

Les figures 2A et 2B représentent des détails d'exécution respectivement du creuset de métal liquide et de l'éjecteur de vapeur selon une modalité d'exécution préférée de la présente invention. La figure 2B illustre en particulier le système aisé d'adaptation du jet de vapeur à la largeur de la bande par simple rotation de l'éjecteur autour de son axe.

Les figures 3A à 3C représentent plusieurs vues de l'éjecteur de vapeur selon la présente invention, illustrant une répartition uniforme du métal vaporisé.

Les figures 4 et 5 représentent des résultats de simulation en mécanique des fluides pour la chambre d'évaporation précitée (respectivement température et vitesse de sortie).

La figure 6 montre une micrographie obtenue pour un dépôt de magnésium sur du fer noir obtenu avec une installation pilote selon la présente invention.

La figure 7 illustre un exemple de régulation de l'ouverture des vannes dans l'installation selon l'invention, ainsi que la vitesse de dépôt moyenne correspondante, au cours du temps pour une température du magnésium liquide égale à 690°C.

La figure 8 représente schématiquement un générateur de vapeur selon l'invention dans une forme d'exécution permettant un dépôt d'alliage de deux métaux purs sur le substrat.

### Description détaillée de l'invention

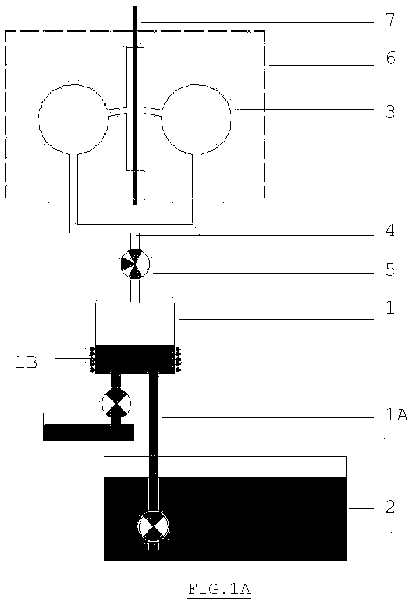

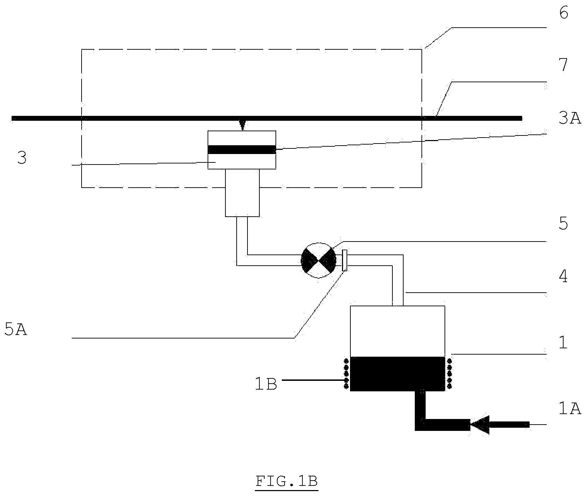

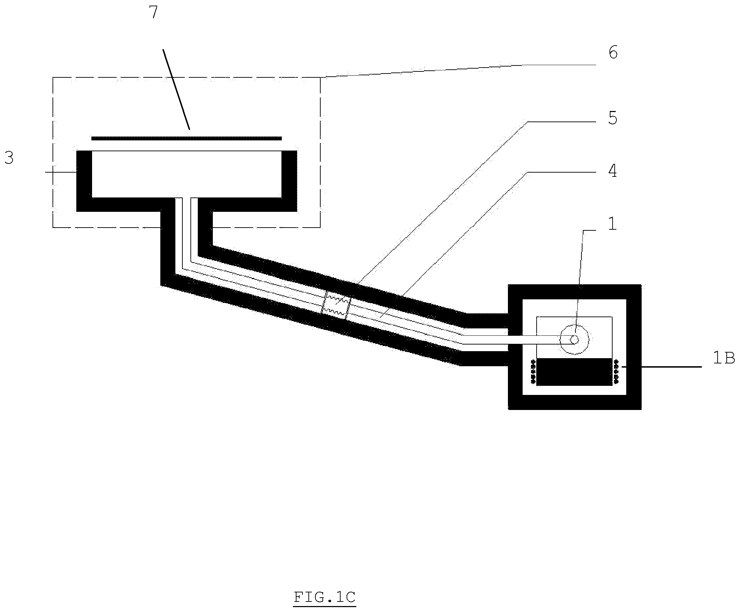

La solution préconisée selon la présente invention consiste à utiliser un creuset d'évaporation qui soit dissocié d'une tête d'éjection JVD à fente longitudinale de sortie de vapeur, appelée ci-après éjecteur. Le principe général d'un tel dispositif est représenté sur la figure 1A. Une autre représentation schématique est donnée sur la figure 1B. La description d'ensemble d'une installation pilote est donnée à la figure 1C. Le creuset 1 est alimenté par une conduite 1A à partir d'un four de fusion de magnésium 2, avec décantation des impuretés. Le type de four de fusion et les conduites utilisés sont des matériels usuellement utilisés dans l'industrie de la fonderie et bien connus de l'homme de métier. Notamment, la fusion et le chargement dans l'appareil selon l'invention se font par des techniques éprouvées.

Le creuset 1 étant déporté et de forme cylindrique, une bonne uniformité de température peut être atteinte grâce à un brassage magnétique important. Le brassage magnétique assuré par un inducteur 1B monté sur ce creuset permet de conserver une homogénéité dans tout le creuset, les ségrégations d'impuretés non évaporées (décantation et flottaison) se faisant dans le four de fusion 2. On assure ainsi la constance dans le temps des conditions d'évaporation et donc de dépôt. Le brassage magnétique est ajusté par la fréquence d'induction en fonction de la nature du creuset et de sa taille.

Le creuset déporté est relié à l'éjecteur 3 (double sur la figure 1A), qui se trouve dans l'enceinte sous vide 6 dans laquelle passe la bande métallique 7, par une conduite cylindrique 4, dont la section est dimensionnée pour obtenir une vitesse lente (la vitesse à la sortie du creuset est idéalement de l'ordre du mètre par seconde à quelques dizaines de mètre par seconde).

L'utilisation d'une conduite cylindrique permet d'obtenir une bonne étanchéité à haute température et au vide en utilisant par exemple une vanne proportionnelle comme une vanne papillon 5 telle que disponible dans le commerce. Le débit de vapeur, qui détermine l'épaisseur de métal déposé, est directement proportionnel à la puissance utile fournie (puissance dans l'inducteur moins pertes thermiques), quelle que soit la position de la vanne proportionnelle. Sans l'utilisation d'une telle vanne ou en utilisant une vanne tout ou rien comme dans EP-A-1 174 526, si on augmente la température de la vapeur, la pression s'ajuste en restant sur la courbe d'équilibre (P, T), mais avec une certaine inertie, c'est-à-dire pas instantanément ou alors en provoquant des transitoires importants suite à l'apport brusque d'énergie. L'utilisation d'une vanne proportionnelle permet d'obtenir, pour une même température, des pressions différentes avant la vanne (au niveau du creuset) et après celle-ci. Si on augmente la puissance fournie, on maintient constante la pression de dépôt dans un premier temps. L'ouverture de la vanne permet ensuite la détente de la vapeur et l'augmentation de pression de dépôt correspondant au point d'équilibre sur la courbe (P, T), c'est-à-dire la pression de vapeur saturante.

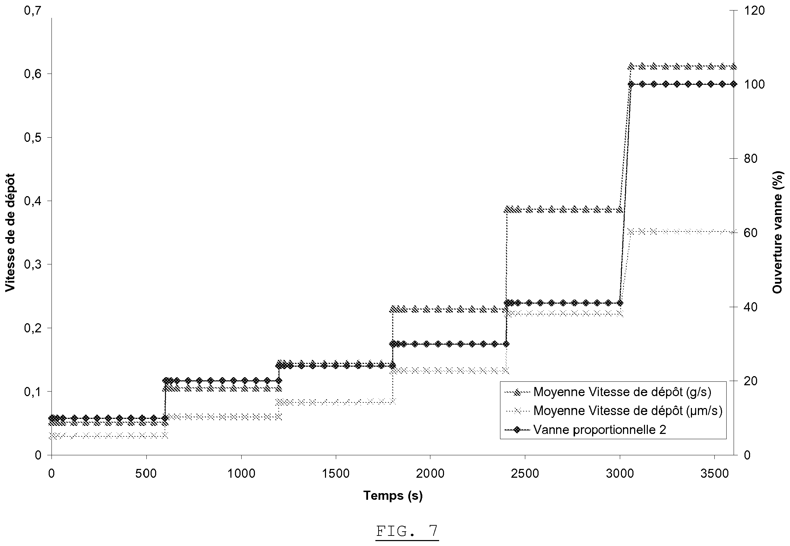

La figure 7 illustre l'utilisation d'une telle vanne papillon 5, avec éventuellement un dispositif de perte de charge 5A, pour la régulation du débit de vapeur. Les débits massiques sont constants pour une position de vanne donnée et les transitoires sont quasi inexistants.

Un autre avantage important est que toute la partie extérieure à l'enceinte sous vide 6 est accessible, le désavantage étant cependant la réalisation obligatoire de l'étanchéité au vide et à haute température au niveau des jonctions dans la partie déportée (non représenté).

Pour chauffer le creuset, la conduite et l'éjecteur, on utilise un chauffage de type four extérieur par rayonnement (de type four cylindrique à fils ou résistances rayonnants). De tels fours sont utilisés en laboratoire jusqu'à une température de 1400-1500°C. Ce four est donc très robuste vu que la température de travail habituelle pour cette application est de l'ordre de 700°C.

Grâce à ce four à rayonnement, la vapeur est surchauffée, ce qui permet de s'éloigner de la température de pression de vapeur saturante et donc du point de condensation. Le risque de recondensation diminue donc. De plus, des simulations numériques ont été effectuées pour déterminer la gamme des vitesses permettant d'éviter la détente adiabatique et donc la condensation suite à la diminution de température qui en découle.

Le fait d'utiliser un chauffage par l'extérieur de la chambre à vide, avec calorifugeage approprié, présente un certain nombre d'avantages:
- maintenance aisée du système de chauffage ;
- isolation et calorifugeage se trouvant à l'extérieur de la chambre à vide, limitant les phénomènes de dégazage sous vide ;
- réduction des problèmes liés à l'utilisation d'éléments chauffants sous vide et liés au refroidissement de leurs connexions électriques ;
- limitation du nombre de cartouches de chauffage sous vide à l'éjecteur, avec limite d'utilisation plus haute (meilleure tenue dans le temps). Par exemple deux cartouches de chauffage à 1100°C sont suffisantes dans le cas du chauffage par rayonnement ;
- utilisation de techniques de chauffage et d'éléments de chauffage robustes et fiables.

### Description de formes d'exécution préférées de l'invention

### Installation générale

Selon une forme d'exécution préférée de l'invention représentée sur la figure 1B, un creuset cylindrique 1, contenant du magnésium fondu, est délocalisé hors de la cuve 6 et en communication avec une tête JVD, en guise d'éjecteur de vapeur de magnésium présentant une fente de sortie disposée transversalement sur toute la largeur de la bande. Selon l'invention, cette dernière peut être disposée indifféremment en brin vertical ou horizontal. Le pompage du magnésium du four de fusion vers le creuset est réalisé au moyen d'une pompe, mais peut également se faire de manière plus simple par dépression, la pression du creuset étant alors inférieure à celle du four de fusion. Les moyens de régulation et l'instrumentation sont disposés hors vide.

L'avantage de ce dispositif est qu'il n'y a pas de magnésium liquide stocké dans la cuve de dépôt, ce qui réduit les inerties, ni de ségrégation de particules d'impuretés sous vide. La conduite 4 de transfert de vapeur est équipée d'un chauffage. La répartition de la vapeur de magnésium sur la largeur de la bande (avant la fente d'éjection) et assurée par un milieu filtrant 3A situé dans l'éjecteur. Cet organe assure en outre la filtration et le réchauffement éventuel de la vapeur qui le traverse. Avantageusement, ce milieu filtrant peut être un filtre en titane fritté, avec une épaisseur de quelques mm ou plus, par exemple 3 mm. Le titane a été retenu parce qu'il n'est pas corrodé par le magnésium liquide et qu'il résiste à la haute température (au contraire du bronze ou d'autres matériaux frittés couramment utilisés). On peut également utiliser avantageusement comme milieu filtrant un « tamis métallique » sous forme de fibres inox frittées, si on peut garantir qu'il n'y aura pas de contact de celui-ci avec le magnésium liquide. Par exemple, on peut utiliser un filtre d'épaisseur 1 mm de SIKA-FIL (GKN Sinter Metals Filters GmbH, Radevormwald, Allemagne). Ces fibres constituent de nattes ayant une porosité allant jusqu'à 85% (DIN ISO 30911-3) et une taille efficace de pores allant de 6 à 60 microns environ (ASTM E 1294).

### Creuset proprement dit

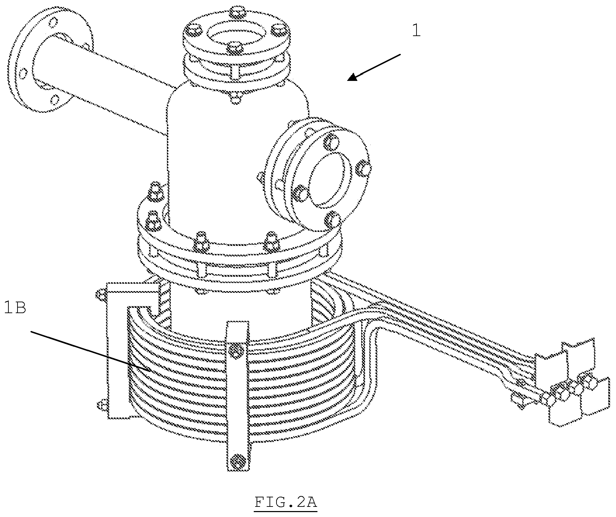

Le creuset 1 selon une forme préférée de l'invention représentée en détail sur la figure 2A, est unique et est facilement accessible pour toute intervention de maintenance. Il est inerte au contact à haute température avec le métal liquide pour sa surface intérieure et résistant à l'oxydation à l'air pour sa surface extérieure.
Il sera de préférence en inox revêtu ou en tout matériau compatible avec le métal à évaporer et avec le contact à l'air à haute température, pour sa partie extérieure. On pourra ainsi choisir par exemple dans le cas du magnésium un colaminé inox-fer doux.

Le chauffage du creuset 1 est conventionnel et réalisé par induction 1B. La fréquence est avantageusement comprise entre 400 et 1000 Hz. D'autres caractéristiques du dispositif mis en oeuvre sont une montée en température de 20 min, taux de chauffage direct du magnésium > 60%, une vitesse de brassage > 1 m/s, etc.

L'inertie thermique est réduite. Le dispositif est pourvu d'une purge du creuset vers le four de fusion par écoulement gravitaire ou pompage, en cas de problème (non représenté).

La régulation du niveau de magnésium dans le creuset est avantageusement réalisée par des moyens de mesure de masse (pesons).

### Ejecteur

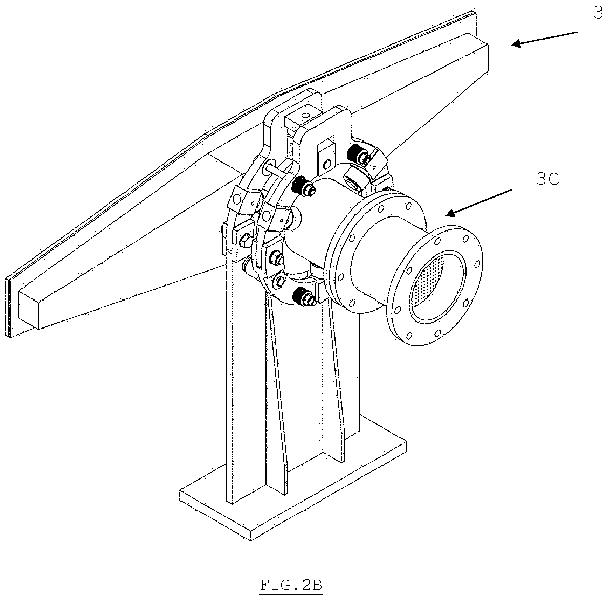

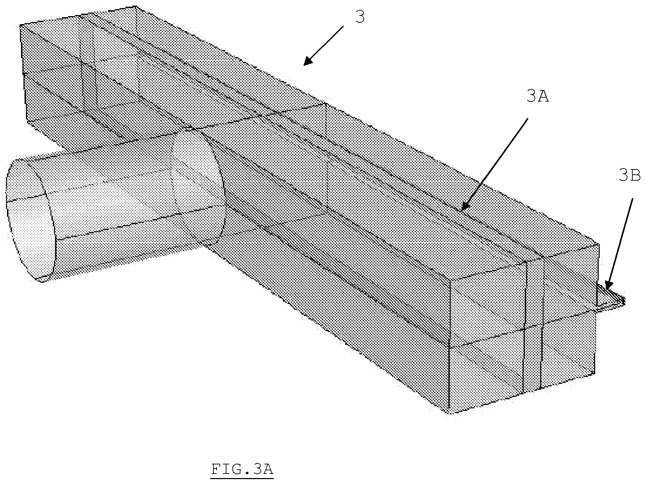

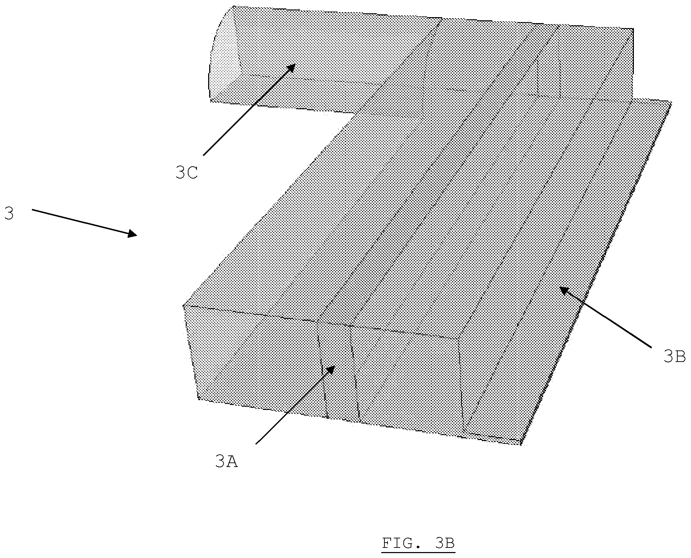

L'éjecteur 3 est représenté en détail sur les figures 2B et 3A à 3C. Il s'agit d'une boîte de longueur supérieure à la largeur de la bande à revêtir. Ce dispositif contient un milieu filtrant ou créant une perte de charge 3A et assurant ainsi l'uniformisation du débit de vapeur sur toute la longueur de la boîte. L'éjecteur 3 est chauffé à température supérieure à celle de la vapeur métallique et est calorifugé extérieurement. Le chauffage peut être interne par cartouches (choix adopté dans la présente forme d'exécution) mais peut également être externe par résistances rayonnantes. Une fente calibrée assure la projection, à la vitesse du son, de la vapeur métallique sur la bande 7. Le col sonique sur toute la longueur de la fente complète très efficacement le milieu filtrant 3A pour assurer l'uniformité du dépôt sur la bande. L'adaptation à la largeur de la bande 7 se fait par rotation de l'éjecteur autour de sa conduite d'alimentation 3B. La figure 2B représente la mécanique interne à la cuve de dépôt qui est alors très simplifiée et fiable. La régulation du débit de vapeur est assurée par la vanne 5 située sur la conduite circulaire 4 (voir figure 1B). Comme déjà mentionné, la figure 7 illustre un exemple de régulation qui peut être réalisée.

### Résultats de simulations et d'essais obtenus avec une installation pilote

Le tableau 1 donne les paramètres d'une installation pilote réalisée pour la mise en oeuvre de l'invention, en comparaison avec les paramètres d'une installation industrielle typique dans le cadre d'une application de dépôt de magnésium.

**Tableau 1**

| | Solution Industrielle | Solution pilote |
|---|---|---|
| Diamètre creuset | 650 mm | 265 mm |
| Hauteur générateur | 1000 mm | 500 mm |
| diamètre conduite | 250 mm | 100 mm |
| Température Travail | 690 - 750 °C | 890 - 750 °C |
| Températures parois | 750 °C | 750 °C |
| Pression de travail | 30 à 70 mbar | 30 à 70 mbar |
| Puissance induction | 160 kW | 50 kW |
| Entendue de travail | 2,5 | 2,5 |
| Volume métal liquide | 82 L | 18 L |
| Ejecteur | 1600 mm | 450 mm |
| Fente | 10 mm | 5 mm |
| Pression éjecteur | qques mmbar | qques mmbar |

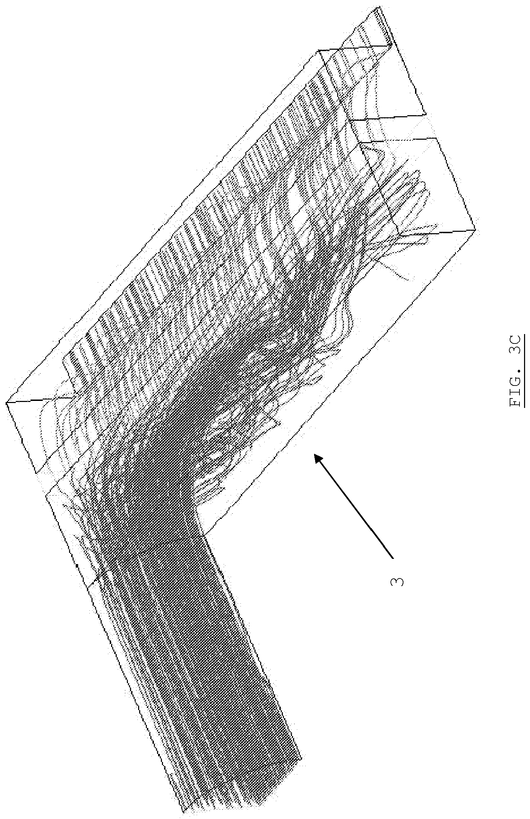

Les figures 3A à 3C montrent différentes vues en perspective de l'éjecteur 3 muni de son filtre en titane fritté 3A et de la fente d'éjection 3B. La figure 3C montre une simulation des trajectoires de vapeur dans la tête d'éjection.

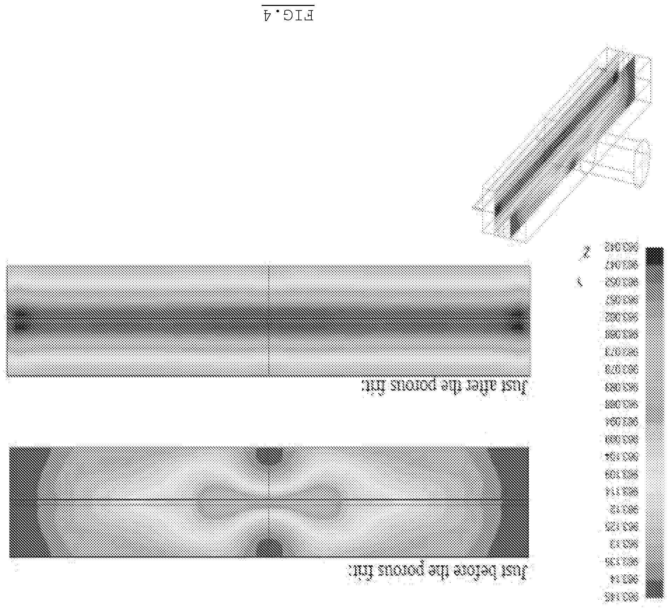

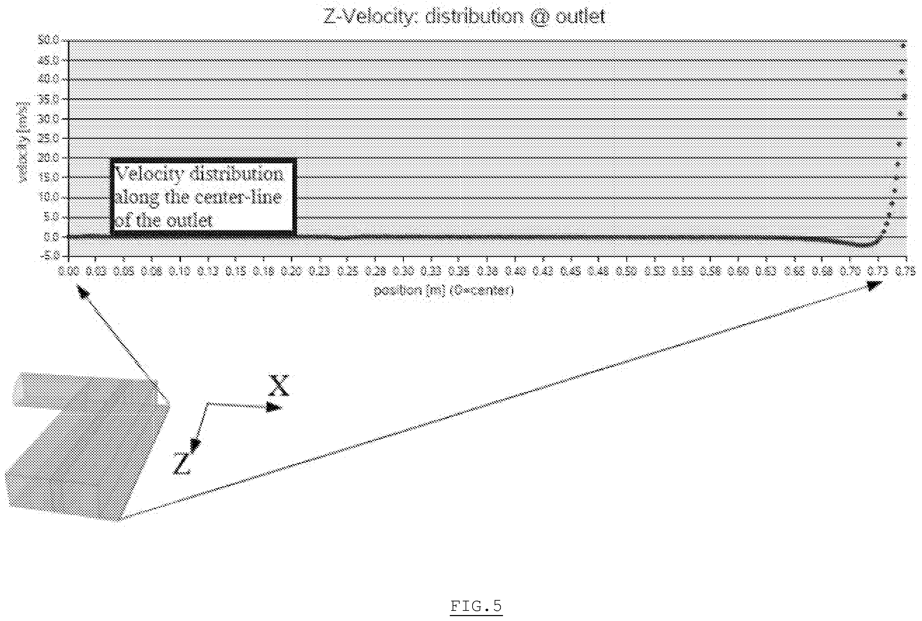

Des résultats d'une simulation numérique en mécanique des fluides, appliquée à l'éjecteur, sont représentés sur les figures 4 et 5. Les différences de température de vapeur avant et après le filtre fritté sont très faibles (0,103K, voir figure 4). La détente est donc quasi isotherme dans le matériau poreux. De plus, la distribution des vitesses le long de la ligne centrale de sortie est pratiquement constante, la direction de la vitesse ne variant significativement que tout près de l'extrémité de la tête (figure 5). Ainsi, le jet de vapeur est presque parfaitement uniforme et isotherme. Le dépôt de vapeur métallique sur la bande sera uniforme en épaisseur et structure cristalline.

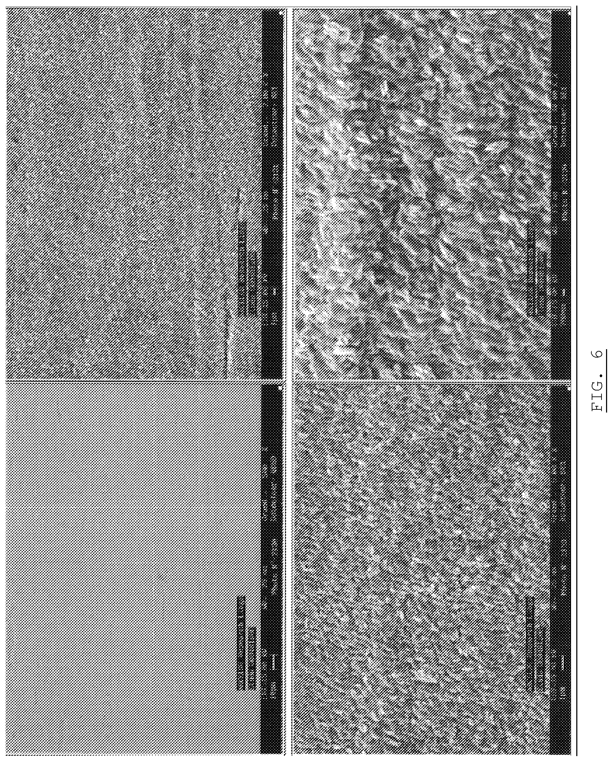

La figure 6 montre, à différents grandissements, le revêtement d'un échantillon de fer noir par du magnésium, obtenu avec l'installation pilote précitée. On peut y constater la bonne homogénéité du dépôt.

D'autre part, le dispositif déporté selon l'invention est particulièrement adapté au dépôt d'alliage par mélange de vapeur car il permet d'ajuster la composition chimique déposée sans avoir à modifier la composition d'un alliage liquide. Le mélange se fait alors dans une conduite à très basse vitesse d'écoulement contrairement à l'état de l'art.

### Mélange des vapeurs de deux métaux de recouvrement différents

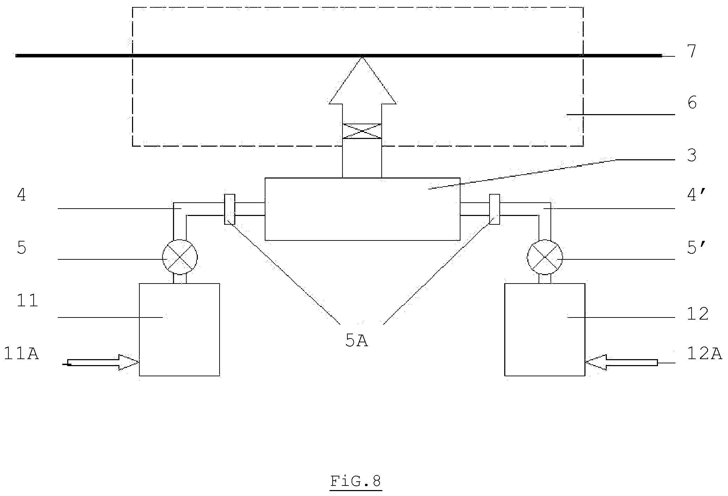

Comme représenté sur la figure 8, deux chambres de fusion 11, 12 contenant respectivement deux métaux purs différents (par exemple zinc et magnésium) sont reliées chacune par une conduite 4, 4' munie d'une vanne 5, 5' à une chambre de mélange couplée à l'éjecteur 3. La concentration des deux métaux dans le mélange est ajustée au moyen des énergies injectées dans les creusets et au moyen des vannes proportionnelles respectives 5, 5', ce qui simplifie le problème de gestion. L'encombrement de ce système est avantageusement réduit.

Un système de perte de charge 5A est utilisé sur chaque conduite, coopérant avec les vannes respectives, ce qui permet l'obtention d'une vapeur à pression plus haute qu'en l'absence de ce système (ex. 20 mbar à 700°C).

Ce dispositif permet également de réguler le débit de vapeur de façon fine et rapide.

### Avantages de l'invention

Le système selon l'invention permet l'obtention d'une très bonne uniformité de la température et de la vitesse de la vapeur déposée, tout en étant fiable et accessible et en ayant de très faibles temps de réponse. L'invention répond ainsi très bien aux exigences d'industrialisation du procédé. Une régulation à basse fréquence du chauffage par induction assure une très bonne uniformité en composition et en température dans le creuset et la régulation du débit de vapeur se fait simplement au moyen d'une vanne située au niveau de la conduite reliant le creuset d'évaporation et l'éjecteur de dépôt et en ajustant l'énergie transmise au métal. Dans WO-A-2005/116290, la régulation du niveau de liquide sous vide, y compris à l'intérieur de la chambre d'évaporation, est effectuée grâce à une pompe magnétohydrodynamique. Contrairement à cet état de la technique, la régulation de niveau selon l'invention se fait par pesée du creuset et la chambre de distribution selon l'invention est un système JVD muni d'une fente ne contenant que de la vapeur du métal à déposer.

## Revendications

1. Générateur de vapeur pour le dépôt d'un revêtement métallique sur un substrat (7), de préférence une bande d'acier, comprenant une chambre à vide (6) sous forme d'une enceinte, munie de moyens pour y assurer un état de dépression par rapport au milieu extérieur et munie de moyens permettant l'entrée et la sortie du substrat (7), tout en étant essentiellement étanche par rapport au milieu extérieur, ladite enceinte englobant une tête de dépôt de vapeur, appelée éjecteur (3), conformé pour créer un jet de vapeur métallique à la vitesse sonique en direction de et perpendiculaire à la surface du substrat (7), ledit éjecteur (3) étant en communication de manière étanche au moyen d'une conduite d'alimentation (4) avec au moins un creuset (1, 11, 12) contenant un métal de revêtement sous forme liquide et situé à l'extérieur de la chambre à vide (6), **caractérisé en ce que** l'éjecteur (3) comprend une fente longitudinale de sortie de la vapeur, jouant le rôle de col sonique, s'étendant sur toute la largeur du substrat, un milieu filtrant ou un organe de perte de charge (3A) en matière frittée étant disposé dans l'éjecteur immédiatement avant ladite fente sur le passage de la vapeur pour uniformiser la vitesse d'écoulement de la vapeur sortant de l'éjecteur (3) par le col sonique.

2. Générateur de vapeur selon la revendication 1, **caractérisé en ce que** ledit milieu filtrant ou organe de perte de charge (3A) est réalisé en titane.

3. Générateur de vapeur selon la revendication 1, **caractérisé en ce que** ledit milieu filtrant ou organe de perte de charge (3A) est un tamis métallique en fibres inox frittées.

4. Générateur de vapeur selon la revendication 1, **caractérisé en ce qu'**il comprend en outre des moyens pour réguler la pression de vapeur métallique dans l'éjecteur (3) sans provoquer d'inertie lors des transitoires de pression.

5. Générateur selon la revendication 4, **caractérisé en ce que** lesdits moyens de régulation comprennent une vanne proportionnelle (5) avec optionnellement un dispositif de perte de charge (5A) disposés dans ladite conduite (4).

6. Générateur selon la revendication 5, **caractérisé en ce que** la vanne proportionnelle (5) est une vanne de type papillon.

7. Générateur selon la revendication 1, **caractérisé en ce qu'**il comporte des moyens pour ajuster la longueur de la fente longitudinale à la largeur du substrat.

8. Générateur selon la revendication 7, **caractérisé en ce que** lesdits moyens comprennent des moyens de rotation de l'éjecteur (3) autour de sa conduite d'alimentation (4).

9. Générateur selon la revendication 1, **caractérisé en ce que** le creuset (1) contient un mélange de métaux sous forme liquide.

10. Générateur selon la revendication 1, **caractérisé en ce que** le creuset (1) est alimenté par pompage ou par gravité du métal liquide à partir d'un four de fusion (2).

11. Générateur selon la revendication 1, **caractérisé en ce que** le creuset (1) comporte un inducteur (1B) monté à l'extérieur, pour assurer le brassage magnétique du métal liquide.

12. Générateur selon la revendication 1, **caractérisé en ce que** le creuset (1) comporte une purge vers le four de fusion (2) par pompage ou écoulement gravitaire.

13. Générateur selon la revendication 1, **caractérisé en ce que** le creuset (1) comporte des moyens de mesure de masse extérieurs pour y réguler le niveau de métal liquide.

14. Générateur selon la revendication 1, **caractérisé en ce que** l'éjecteur (3), la conduite (4) et le creuset (1) sont isolés thermiquement du milieu extérieur et chauffés par un four à rayonnement.

15. Générateur selon la revendication 1, **caractérisé en ce qu'**il comporte des moyens de chauffage optionnels de l'enceinte sous vide (6).

16. Générateur selon la revendication 1, **caractérisé en ce qu'**il comporte deux creusets (11, 12) contenant des métaux sous forme liquide différents.

17. Générateur selon la revendication 16, **caractérisé en ce que** chaque creuset (11, 12) est relié par une conduite propre (4, 4') à un mélangeur, lui-même en communication avec l'éjecteur (3).

18. Générateur selon la revendication 17, **caractérisé en ce que** chaque conduite (4, 4') comporte une vanne (5, 5') avec optionnellement un dispositif de perte de charge (5A) permettant l'ajustement des concentrations de chaque métal lors du mélange des vapeurs à déposer sur le substrat (7) et la régulation de la pression des vapeurs métalliques dans le mélangeur sans provoquer d'inertie lors des transitoires de pression.

19. Générateur selon la revendication 18, **caractérisé en ce que** le mélangeur est l'éjecteur (3) lui-même et comporte un milieu filtrant en matière frittée permettant d'uniformiser la vitesse d'écoulement de la vapeur de chaque métal sortant de l'éjecteur(3).

20. Générateur de vapeur selon la revendication 19, **caractérisé en ce que** ledit milieu filtrant en matière frittée est réalisé en titane ou se présente sous la forme d'un tamis métallique en fibres inox frittées.

## Patentansprüche

1. Erzeuger von Dampf für das Ablagern einer Metallschicht auf einem Substrat (7), vorzugsweise einem Stahlband, aufweisend eine Vakuumkammer (6) in Form einer Einschließung, die mit Mitteln ausgestattet ist, um dort relativ zu der Außenumgebung einen Unterdruckzustand sicherzustellen, und die mit Mitteln ausgestattet ist, die das Eintreten und das Austreten des Substrats (7) ermöglichen, wobei sie gleichzeitig relativ zu der Außenumgebung im Wesentlichen dicht ist, wobei die Einschließung einen Dampfabscheidungskopf aufweist, der als Ejektor (3) bezeichnet wird, der angepasst ist, um mit Schallgeschwindigkeit einen Metalldampfstrahl in Richtung zu und senkrecht zu der Fläche des Substrats (7) zu erzeugen, wobei der Ejektor (3) mittels einer Versorgungsleitung (4) auf dichte Weise mit mindestens einem Schmelztiegel (1, 11, 12) kommuniziert, der ein Beschichtungsmetall in flüssiger Form enthält und außerhalb der Vakuumkammer (6) angeordnet ist, **dadurch gekennzeichnet, dass** der Ejektor (3) einen Längsausgangsschlitz für den Dampf aufweist, der die Rolle einer Schallverengung spielt, der sich über die gesamte Breite des Substrats erstreckt, wobei ein Filtermedium oder ein Ladungsverlustmittel (3A) aus gesintertem Material in dem Ejektor direkt vor dem Schlitz auf dem Durchgang für den Dampf angeordnet ist, um die Strömungsgeschwindigkeit des Dampfes, der durch die Schallverengung aus dem Ejektor (3) austritt, zu vereinheitlichen.

2. Dampferzeuger gemäß Anspruch 1, **dadurch gekennzeichnet, dass** das Filtermedium oder Ladungsverlustmittel (3A) aus Titan hergestellt ist.

3. Dampferzeuger gemäß Anspruch 1, **dadurch gekennzeichnet, dass** das Filtermedium oder Ladungsverlustmittel (3A) ein Metallsieb aus gesinterten Edelstahlfasern ist.

4. Dampferzeuger gemäß Anspruch 1, **dadurch gekennzeichnet, dass** er ferner Mittel zum Regulieren des Metalldampfdrucks in dem Ejektor (3) aufweist, ohne bei Druckübergangsvorgängen eine Trägheit zu verursachen.

5. Erzeuger gemäß Anspruch 4, **dadurch gekennzeichnet, dass** die Regulierungsmittel ein Proportionalventil (5) optional mit einer Ladungsverlustvorrichtung (5A) aufweisen, die in der Leitung (4) angeordnet sind.

6. Erzeuger gemäß Anspruch 5, **dadurch gekennzeichnet, dass** das Proportionalventil (5) ein Ventil des Drosselklappentyps ist.

7. Erzeuger gemäß Anspruch 1, **dadurch gekennzeichnet, dass** er Mittel zum Anpassen der Länge des Längsschlitzes an die Breite des Substrats aufweist.

8. Erzeuger gemäß Anspruch 7, **dadurch gekennzeichnet, dass** die Mittel Mittel zum Drehen des Ejektors (3) um seine Versorgungsleitung (4) aufweisen.

9. Erzeuger gemäß Anspruch 1, **dadurch gekennzeichnet, dass** der Schmelztiegel (1) eine Mischung aus Metallen in flüssiger Form enthält.

10. Erzeuger gemäß Anspruch 1, **dadurch gekennzeichnet, dass** der Schmelztiegel (1) durch Pumpen oder durch die Schwerkraft des flüssigen Metalls aus einem Schmelzofen (2) gespeist wird.

11. Erzeuger gemäß Anspruch 1, **dadurch gekennzeichnet, dass** der Schmelztiegel (1) einen Induktor (1B) aufweist, der außen montiert ist, um das magnetische Mischen des flüssigen Metalls sicherzustellen.

12. Erzeuger gemäß Anspruch 1, **dadurch gekennzeichnet, dass** der Schmelztiegel (1) einen Ablass in Richtung des Schmelzofens (2) durch Pumpen oder Strömen durch Schwerkraft aufweist.

13. Erzeuger gemäß Anspruch 1, **dadurch gekennzeichnet, dass** der Schmelztiegel (1) äußere Mittel zur Massemessung aufweist, um das Flüssigmetall-Niveau darin zu regulieren.

14. Erzeuger gemäß Anspruch 1, **dadurch gekennzeichnet, dass** der Ejektor (3), die Leitung (4) und der Schmelztiegel (1) thermisch von der äußeren Umgebung isoliert und durch einen Strahlungsofen beheizt sind.

15. Erzeuger gemäß Anspruch 1, **dadurch gekennzeichnet, dass** er optionale Mittel zum Beheizen der Vakuumeinschließung (6) aufweist.

16. Erzeuger gemäß Anspruch 1, **dadurch gekennzeichnet, dass** er zwei Schmelztiegel (11, 12) aufweist, die verschiedene Metalle in flüssiger Form enthalten.

17. Erzeuger gemäß Anspruch 16, **dadurch gekennzeichnet, dass** jeder Schmelztiegel (11, 12) durch eine eigene Leitung (4, 4') mit einem Mischer verbunden ist, der seinerseits mit dem Ejektor (3) kommuniziert.

18. Erzeuger gemäß Anspruch 17, **dadurch gekennzeichnet, dass** jede Leitung (4, 4') ein Ventil (5, 5') mit optional einer Ladungsverlustvorrichtung (5A) aufweist, welches das Anpassen der Konzentrationen von jedem Metall beim Mischen der Dämpfe, die auf das Substrat (7) abzulagern sind, und das Regulieren des Drucks der Metalldämpfe in dem Mischer ermöglicht, ohne bei den Druckübergangsvorgängen eine Trägheit zu verursachen.

19. Erzeuger gemäß Anspruch 18, **dadurch gekennzeichnet, dass** der Mischer der Ejektor (3) selbst ist und ein Filtermedium aus gesintertem Material aufweist, welches ermöglicht, die Strömungsgeschwindigkeit des Dampfes jedes Metalls zu vereinheitlichen, der aus dem Ejektor (3) austritt.

20. Dampferzeuger gemäß Anspruch 19, **dadurch gekennzeichnet, dass** das Filtermedium aus gesintertem Material aus Titan hergestellt ist oder in Form eines Metallsiebs aus gesinterten Edelstahlfasern vorliegt.

## Claims

1. Vapour generator for deposition of a metal coating on a substrate (7), preferably a steel strip, comprising a vacuum chamber (6) in the form of an enclosure, provided with means to produce a low pressure compared to the exterior environment and provided with means enabling the entry and exit of the substrate (7), all while being essentially sealed with respect to the exterior environment, said enclosure incorporating a vapour deposition head, called ejector (3), adapted to create a jet of metal vapour at sonic velocity towards and perpendicular to the surface of the substrate (7), said ejector (3) being in sealed communication by means of a supply duct (4) with at least one crucible (1, 11, 12) containing a coating metal in liquid form and situated outside the vacuum chamber (6), **characterized in that** the ejector (3) comprises a longitudinal exit slot for the vapour, acting as a sonic throat, extending over the full width of the substrate, a filtering medium or a head loss member (3A) made of sintered material being disposed in the ejector immediately before said slot upon the passage of the vapour in order to equalize the velocity of flow of the vapour leaving the ejector (3) by the sonic throat.

2. Vapour generator according to claim 1, **characterised in that** said filtering medium or head loss member (3A) is made of titanium.

3. Vapour generator according to claim 1, **characterised in that** said filtering medium or head loss member (3A) is a metal sieve with sintered stainless steel fibres.

4. Vapour generator according to claim 1, **characterised in that** it further comprises means for regulating the metal vapour pressure in the ejector (3) without causing inertia during pressure transients.

5. Generator according to claim 4, **characterised in that** said regulation means comprise a proportional valve (5) optionally with a head loss device (5A) disposed in said duct (4).

6. Generator according to claim 5, **characterised in that** the proportional valve (5) is a butterfly type valve.

7. Generator according to claim 1, **characterised in that** it comprises means for adjusting the length of the longitudinal slot to the width of the substrate.

8. Generator according to claim 7, **characterised in that** said means comprise means of rotating the ejector (3) around its supply duct (4).

9. Generator according to claim 1, **characterised in that** the crucible (1) contains a mixture of metals in liquid form.

10. Generator according to claim 1, **characterised in that** the crucible (1) is supplied with liquid metal by pumping or by gravity from a melting furnace (2).

11. Generator according to claim 1, **characterised in that** the crucible (1) comprises an inductor (1B) mounted on the exterior, to provide the magnetic stirring of the liquid metal.

12. Generator according to claim 1, **characterised in that** crucible (1) comprises a drain towards the melting furnace (2) by pumping or gravity flow.

13. Generator according to claim 1, **characterised in that** the crucible (1) comprises exterior mass measuring means to regulate the level of liquid metal.

14. Generator according to claim 1, **characterised in that** the ejector (3), the duct (4) and the crucible (1) are thermally insulated from the exterior environment and heated by a radiation furnace.

15. Generator according to claim 1, **characterised in that** it comprises optional means of heating the vacuum chamber (6).

16. Generator according to claim 1, **characterised in that** it comprises two crucibles (11, 12) containing different metals in liquid form.

17. Generator according to claim 16, **characterised in that** each crucible (11, 12) is connected by its own duct (4, 4') to a mixer, which is in communication with the ejector (3).

18. Generator according to claim 17, **characterised in that** each duct (4, 4') comprises a valve (5, 5'), optionally with a head loss device (5A), enabling the concentration of each metal to be adjusted during the mixing of the vapours to be deposited on the substrate (7), and the pressure of the metal vapours to be regulated in the mixer without causing inertia during pressure transients.

19. Generator according to claim 18, **characterised in that** the mixer is the ejector (3) itself and comprises a filtering medium of sintered material enabling the flow velocity of the vapour to be equalized for each metal leaving the ejector (3).

20. Generator according to claim 19, **characterised in that** said filtering medium of sintered material is produced from titanium or is in the form of a metal sieve made of sintered stainless steel fibres.
